# EUROPEAN PATENT APPLICATION

(11) **EP 0 620 201 A2**
(43) Date of publication of application: **19.10.1994**
(21) Application number: 94302570.0
(22) Date of filing: 12.04.1994
(51) Int. Cl.: C03C 17/32, C03C 15/00, G02B 3/00, C04B 41/91

(54) **Method of manufacturing mircro-optical elements**

(30) Priority: 12.04.1993 US 46060
(71) Applicant: Hughes Aircraft Company, Los Angeles, California 90045-0066 (US)
(72) Inventor: Gratrix, Edward J., Trumbull, Connecticut 06611 (US)
(74) Representative: Colgan, Stephen James

(57) **Abstract**

A method of manufacturing micro-optical elements includes a first isotropic etching step of a plurality of openings **16** exposed through a layer **12** of a masking material on substrate **10** and a subsequent generalized etching step of the entire surface of the substrate **10** after the layer **12** is removed.

## Description

### BACKGROUND OF THE INVENTION

The present invention generally relates to the manufacture of micro-optical elements and, in particular, relates to one such method including both a selective etching step and a generalized etching step.

As used herein the phrase "micro-optical element" is taken to mean those optical elements that are not reasonably susceptible to manufacture by standard manufacturing techniques. More specifically, the phrase micro-optical element is taken to mean those optical elements that are not reasonably susceptible to fabrication by standard optical grinding and polishing techniques. In many fields of endeavor there is growing need for micro-optical elements. For example, in the general field of optics there is a need for micro-optical elements to keep pace with the many improvements in both optical materials and optical electronic materials. In the micro-optical element field, in particular, there has been an increased demand for high resolution micro-optical elements to support the application of new materials and circuitry. For example, the widespread use of optical fibers has increased the demand for high quality micro-optical elements. In addition, considerable effort is being directed to the development of optical detector arrays.

One of the difficulties facing both end users and the manufactures of such micro-optical elements is the consistency of manufacture as well as the ability to manufacture the devices to ever tightening specifications.

In general, such techniques include the use of lasers to cut or otherwise microscopically form the particular elements desired. However, such techniques are time intensive and applicable only over limited areas of the piece being manufactured. Another way of manufacturing micro-optical elements is by use of replication using masters formed by either a laser assisted chemical etching (LACE) process or other such means. The difficulty with using master replication, for example, in non-optical applications is that the master must come in contact with the substrate and this allows, in many instances, for errors to be introduced as well as reduced effectiveness due to the limitations on the radius of curvature of the various elements. Further, the manufacture of large numbers of micro-optical lenses covering a large area is difficult to achieve and is currently very time consuming

In addition, in many fields of endeavor other than optical elements there is a growing need for micro-elements. For example, in the instrumentation field there is a need for micro-capillaries that may be applicable for gas chromatography instruments as well as useful in the medical fields.

From the above discussion it seems quite clear that there is a significant need and desire for a method of manufacturing micro-optical elements that overcomes the above recited drawbacks and has applications throughout various industries.

### SUMMARY OF THE INVENTION

Accordingly, it is one object of the present invention to provide a method of manufacturing micro-optical elements in such a manner that the above recited difficulties of conventional techniques are substantially obviated.

This object is accomplished, at least in part, by a method of manufacturing micro-optical elements that includes both a selective etching step and a generalized etching step.

Other objects and advantages of the present method will become apparent to those skilled in the art from the following detailed description of the invention read in conjunction with the appended claims and the drawings attached hereto.

### BRIEF DESCRIPTION OF THE DRAWINGS

The drawings, not drawn to scale, are:
Figures 1A-1E is a step-by-step representation of the application of the simultaneous fabrication of a plurality of micro-optical elements employing a method according to the principles of the present invention;
Figure 2 is a cross-sectional representation of the fabrication of an aspherical lenslet according to the principles of the present invention;
Figure 3 is a cross-sectional view of a lenslet array assembly employing a lenslet array manufactured in accordance with the principles of he present invention;
Figure 4 is a top view of a mask opening useful in conjunction with the method embodying the principles of the present invention;
Figure 5 is a cross-sectional view of a lenslet resulting from the mask opening shown in Figure 4; and
Figure 6 is a perspective view of a row of cylindrical lenslets manufactured in accordance with the principles of the present invention.

### DETAILED DESCRIPTION OF THE INVENTION

As is well known in most manufacturing fields, one of the more inexpensive manufacturing techniques is the replication of a shape by pressing a master, that has the desired shape formed in relief on a surface thereof, into a malleable material. One particular example of this manufacturing technique is the fabrication of phonograph records. Heretofore, this type of manufacturing technique has not been efficiently developed for the fabrication of micro-lenses or other micro-elements. Hence, such a fabrication of a master for a micro-lens array is discussed herein as an exemplary model employing the method of the present invention.

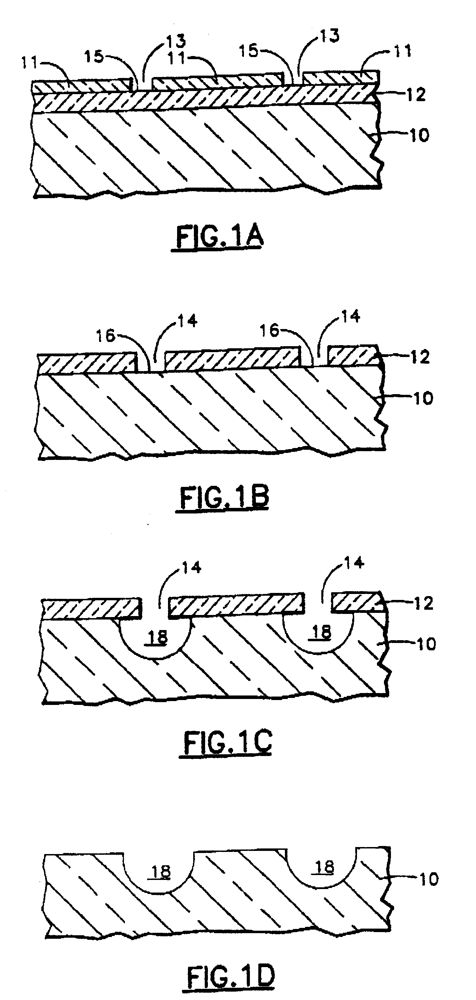

As shown in Figure 1A, a substrate **10** that is to ultimately be used as a master for replication of micro-lenslet arrays is provided with a layer **12** of masking material and a layer **11** of photosensitive material overlying the layer **12** of masking material.

In the preferred embodiment, the layer **11** can be any conventional photoresist. As shown, a plurality of openings **13** are formed in the layer **11** to expose portions **15** of the masking layer **12** thereunder. Typically, the openings **13** are formed by the use of known highly accurate photolithographic techniques.

Although the openings **13** through the layer **11** of masking material are referred to as "pinholes" it is understood that lenslet geometries other than "holes" can be fabricated. That is, because of the use of the highly accurate process of photolithography, the cross-section of the openings **13** need not be circular but can also be square, hexagonal, or the like. Preferably, the materials of the substrate **10** and the layer **12** of the masking material are selected so that the relative etch rates for the material of the substrate **10** to the layer **12** of masking material is large, i. e., greater than about 100. Such a choice of materials thereby ensures an effective selective etch.

In this particular embodiment, the material of the substrate **10** may be silicon and the layer **12** of masking material may be, for example, silicon dioxide, or the like, depending upon the particular etchant composition selected. In this particular embodiment, as shown in Figure 1B, a plurality of openings **14**, i. e., pinholes, are formed in the layer **12** of masking material to expose portions **16** of the substrate **10**. Typically, such pinboles **14** are on the order of a few micrometers in diameter. The pinholes **14** can then be opened by use of ion milling or a simple chemical etching process.

After the openings **14**, or pinholes, are formed to expose the portions **16** of the substrate **10**, the layer **11** of photosensitive material is removed and the entire substrate **10** is subjected to an isotropic etch during which selective etching of the substrate **10** occurs at the exposed portions **16**. It has been determined that during the etching step, cavities **18** are formed in the substrate **10** in accordance with length of time that each pinhole **14** is exposed to the etchant. In the case where the process, as shown in Figure 1C, is an isotropic etch, the cavities **18** are hemispherical with having radii of curvature equal to the total depth of the etch. The hemispherical cavities **18** will be centered in the same locations as the original exposed portions **16**.

In one preferred embodiment, the mask or selective etching step is carried out by use of a plasma etching system. Although. alternatively a conventional wet chemical etching method can be employed. The advantage of a plasma etching system, however, is that it is more rapid than using a conventional wet chemical etchant.

As depicted in Figure 1D, the remaining material of the layer **12** of masking material is then removed in accordance with conventional photolithographic techniques.

After the material of the layer **12** of masking material is removed, the entire substrate **10** is exposed to a generalized isotropic etch which may again either be a plasma etch or a chemical etch. As shown in Figure 1E, during this etch, it has been found that the radius of curvature of each of the lenslets increases with the depth of the etch. Nevertheless, during the generalized isotropic etch, the radius of curvature nonetheless remains centered on the previously exposed portions **16**. The generalized unmasked etch is, in this particular embodiment, allowed to continue until the individual lenslet intercept each other i.e. the radius of curvature of each lenslet becomes equal to about half the distance between two horizontally or vertically adjacent exposed portions **16**. In this manner, a lenslet array **20** having a full fill factor is provided.

The provision of a full fill factor lenslet array **20** is advantageous since, by definition, all of the light impinging on the array **20** is captured by one of the lenslets and therefore there is no loss in optical efficiency. In this particular embodiment, the resultant structure in the silicon substrate **10** is, effectively, a master that may be employed to fabricate to subsequent microlenslet arrays **20** in other materials such as, for example, plastic.

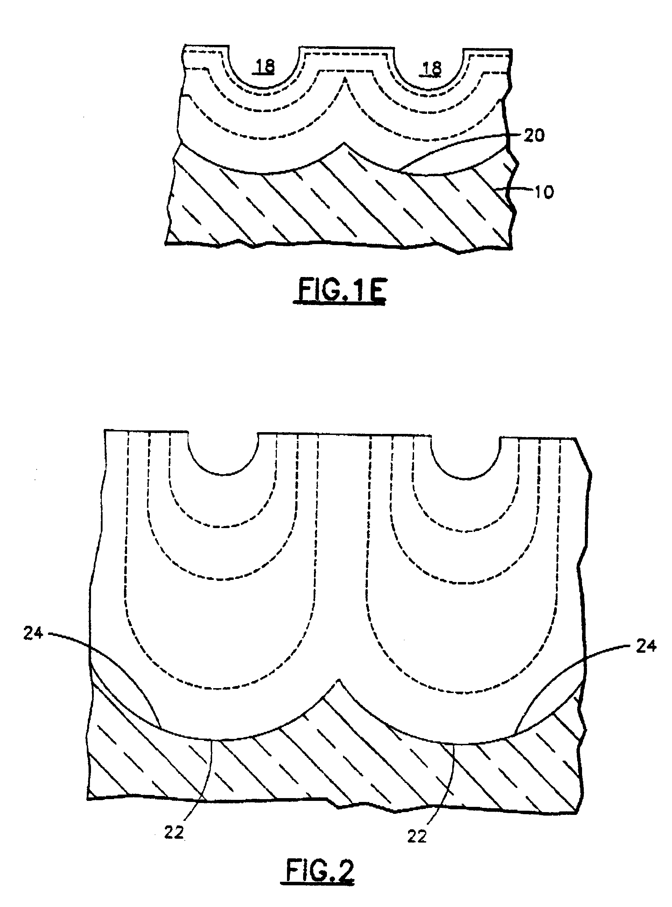

As described hereinabove, the lenslets of the lenslet array **20** are spherical lenslets. However, the present method is not so limited. As shown in Figure 2, as array **22** of aspheric lenslets **24** can be formed by employing an anisotropic etch during both the first and second etch steps through the layer **12** of masking material and the subsequent generalized etch step performed subsequent to the removal of the layer **12** of masking material. Alternatively, the first etch step can be anisotropic and the second etch step isotropic, or vice versa.

As stated, the formation of aspherical lenslets can be accomplished by use of anisotropic etching steps. Such anisotropic etching can generally be ensured by, in the use of a localized plasma etching step, altering the plasma etching conditions, i. e., the reactive gases, by varying the d. c. bias, by varying the plasma background pressure, or the like. In the instance of wet chemical etching general anisotropic etching techniques are known. Typically, the etchant is selected to have different etch rates along one or more of the crystal lattice plane orientation of the substrate **10**..

Although the above description quite effectively results in a master lenslet array that can be used to replicate other lenslet arrays, alternatives employing additional processing steps are available.

As shown in Figure 3, the lenslet array **20** of a lenslet array assembly is fabricated according to the method recited above. However, in this case, the substrate **10** of the array **20** is a light transmissive material, such as fused silica. The array **20** is provided with layer **26** of light transmissive material, or medium. Preferably, the material of the layer **26** of light transmissive material has an index of refraction different than the index of refraction of the substrate **10**. In one particular embodiment, the layer **26** can be any conventional optical epoxy commonly used to bind lenses, or other optical elements, together. Thereafter, a light transmissive coverslip **28** is added to complete the assembly of a positive lenslet array if formed. As known, a coverslip is, essentially, a piece of glass, plastic, or other optically transparent material, used to establish a planar surface in the optical epoxy.

In one specific embodiment, a lenslet array **20** is fabricated to collimate the output of an array of laser diodes. In such an embodiment, the diodes may be, for example, spaced on 200 micrometer centers in a 10 by 10 array. Hence, the lenslet array **20** geometry is also made with individual lenslets on 200 micrometer centers in a 10 by 10 array. A typical laser diode beam diverges an f/5 cone, therefore, an f/5 lenslet is needed to collimate the diode array. Further, in such a system the focal length is, typically, about 1 millimeter.

Therefore, if the material of the substrate **10** is selected with an index of refraction (n) of about 1.4, typical of fused silica, and the index of refraction of the layer **26** of light transmissive material has an index of refraction (n') of about 1.7, typical of optical epoxy for matching crown glass, then based on the formula R=f(n'-n)/n'; wherein R is the radius of curvature of the lens and f is the focal length, the radius of curvature of each lenslet should be about 176.5 micrometers. For such a specification, the openings **14** are formed with about 5 micrometer diameters. The isotropic etch through the openings **14** is continued until hemispherical cavities **18** are generated to about **50** micrometer radius. Thereafter, the layer **12** of masking material is removed and the entire substrate **10** is subjected to a generalized etch until the lenslets reach a radius of curvature of about 176.5 micrometers. Thereafter, layer **26** of the n' medium is applied and the coverslip **28** added. The index of refraction of the coverslip **28** will ordinarily have negligible impact on the determination of the radius of curvature of the lenslets of the lenslet array **20**.

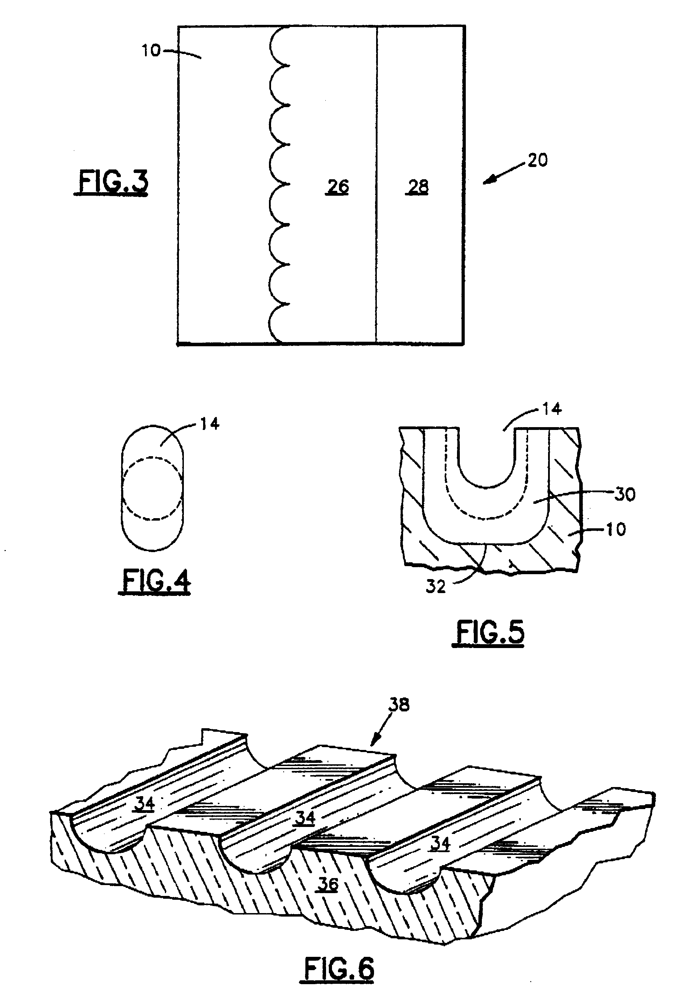

It will be understood that almost any shape can be fabricated such as any ellipse or cylindrical lens as shown in Figures 4, 5 and 6. Referring to Figure 4, wherein elements previously discussed are identified by the same reference numerals, the original mask openings **14** are extended in one direction and as a result during the subsequent etchings, i. e., both the selective and generalized etches an elliptical cross-sectional lenslet shown at **30** Figure 5 is formed. The elliptical lenslet **30** so formed will have a larger radius of curvature in one direction than the other, the larger radius is equal to the original radius plus the length equal to the expanded portion of the opening. The smaller radius is similar to the lenslets of the lenslet array **20**. It has been determined, however, that lenslets formed in this manner may have slightly flat bottoms **32**, i.e. it is not a perfect spherical or hemispherical surface, however, the resulting flatness is minimal with respect to the general application of such formed ellipses.

As shown in Figure 6, a plurality of cylindrical lenslets **34** can also be manufactured in a transparent substrate material **36** in accordance with the principles of the present invention. It will be understood, however, that an array **38** of cylindrical lenslets **34** can, of course, be processed to provide a full fill factor. Such an array **38** of cylindrical lenslets **34** can have numerous application, such as, for example, serving in a laser beam combiner wherein a semiconductor laser is associated with each lenslet **34** whereby the array **38** acts to provide a single output laser beam that has uniform illumination across the beam cross-section.

Although the present invention has been described with respect to one or more particular embodiments of the method, it will be understood that other method steps and other articles may be manufactured without departing from the spirit and scope of the present invention. Hence, the present invention is deemed limited only by the appended claims and the reasonable interpretation thereof.

## Claims

1. A method of manufacturing micro-elements; said method comprising the steps of:
coating a surface of a substrate with a layer of masking material;
forming at least one opening through said mask material to expose selected portions of said substrate;
exposing said selected portions of said substrate to an isotropic etch such that said portions of said substrate are etched;
removing said mask material from said substrate material; and
exposing said substrate to a generalized isotropic etch process.

2. Method of manufacturing micro-elements as claimed in Claim 1 wherein said generalized etching step is continued until the radii of each opening intercepts the adjacent etched opening.

3. Method as claimed in Claim 1, further comprising the step of:
providing a substrate material and a mask material having an etch rate ratio of about 100.

4. Method as claimed in Claim 1; wherein said forming step includes forming a circular opening.

5. Method as claimed in Claim 1 wherein said forming step includes forming an elliptical opening.

6. Method as claimed in Claim 1 wherein said exposing step includes exposing said selected portions to isotropic plasma reactive etching.

7. Method as claimed in Claim 1 wherein said forming step includes forming an array of openings through said layer of masking material such that an array of selected openings of said substrate are exposed.

8. Method as claimed in Claim 1 wherein said openings are parallel lines and said micro-elements are cylindrical lenslets.

9. A method of manufacturing micro-elements; said method comprising the steps of:
coating a surface of a transparent substrate a with a layer of masking material;
forming at least one opening through said mask material to expose selected portions of said substrate;
exposing said selected portions of said substrate to an anisotropic etch such that said portions of said substrate are etched;
removing said mask material form said substrate material;
exposing said substrate to a generalized isotropic etch process;
applying a transparent medium to said surface of said transparent substrate; and
providing a coverslip over said medium whereby a micro-optical assembly is provided.

10. Method as claimed in Claim 9 wherein said method further comprises selecting a medium having an index of different than the index of refraction of said transparent substrate.

11. Method as claimed in Claim 10 wherein said applying step includes applying a transparent epoxy to said surface of said transparent substrate.
